# EUROPEAN PATENT APPLICATION

(11) **EP 4 317 722 A1**
(43) Date of publication of application: **07.02.2024**
(21) Application number: 22781233.6
(22) Date of filing: 31.03.2022
(51) Int. Cl.: F16C 29/00, F16C 32/00, G03F 7/20, H01L 21/68

(54) **STAGE APPARATUS, EXPOSURE APPARATUS, INSPECTION APPARATUS, AND DEVICE MANUFACTURING METHOD**

(30) Priority: 01.04.2021 JP 2021062640
(71) Applicant: Sumitomo Heavy Industries, Ltd., Tokyo 141-6025 (JP)
(72) Inventor: YOSHIDA Tatsuya, Yokosuka-shi Kanagawa 237-8555 (JP)
(74) Representative: Louis Pöhlau Lohrentz
(86) International application number: PCT/JP2022/016511
(87) International publication number: WO 2022/211023

(57) **Abstract**

A stage apparatus (100) includes: a first slider (14); a first guide (12) that guides movement of the first slider (14) in a first direction; a second slider (18) that includes two slider parts (32, 34) separated from each other in the first direction and supporting the first guide (12) from below; and a second guide (16) that guides movement of the second slider (18).

## Description

### Technical Field

The present invention relates to a stage apparatus, an exposure apparatus, an inspection apparatus, and a device manufacturing method.

### Background Art

An exposure apparatus or an inspection apparatus used in a process of manufacturing a device of a semiconductor device includes a stage for moving an exposed substrate. The stage is supported and positioned by, for example, a guide.

In the related art, a stage apparatus called a stack type with one guide in a first direction and one guide in a second direction has been proposed (for example, PTL 1). This stack-type stage apparatus generally includes a first slider, a first guide that guides movement of the first slider in a first direction, a second slider that supports the first guide, and a second guide that guides movement of the second slider in a second direction.

### Citation List

### Patent Literature

[PTL 1] Japanese Unexamined Patent Publication No. H5-57558

### Summary of Invention

### Technical Problem

In the stack-type stage apparatus, when the first slider moves, a load fluctuates on the first guide, the first guide tilts around the second direction, and a moment around the second guide may occur in the second slider that supports the first guide. This can cause galling where the second slider comes into contact with the second guide.

The present invention has been made in view of such a situation, and an object of the present invention is to provide a technique that can prevent galling caused by a slider coming into contact with a guide.

### Solution to Problem

In order to solve the above problems, a stage apparatus according to an aspect of the present invention includes: a first slider; a first guide that guides movement of the first slider in a first direction; a second slider that includes two slider parts separated from each other in the first direction and supporting the first guide from below; and a second guide that guides movement of the second slider.

Another aspect of the present invention is an exposure apparatus. This exposure apparatus includes the stage apparatus described above, and positions a substrate by using the stage apparatus.

Still another aspect of the present invention is an inspection apparatus. This inspection apparatus includes the stage apparatus described above, and positions a substrate by using the stage apparatus.

Still another aspect of the present invention is a device manufacturing method. This device manufacturing method includes a step of manufacturing a device by using the exposure apparatus described above.

Any combination of the constituent elements described above and a combination obtained by replacing the constituent elements and expressions of the present invention between apparatuses, methods, and systems are also effective as an aspect of the present invention.

### Advantageous Effects of Invention

According to the present invention, galling caused by the slider coming into contact with the guide can be prevented, and stable movement of the slider can be implemented.

### Brief Description of Drawings

Fig. 1 is a perspective view of a stage apparatus according to an embodiment.
Fig. 2 is a perspective view of a Y-axis guide and a Y-axis slider of the stage apparatus of Fig. 1.
Fig. 3 is a cross-sectional view of the stage apparatus of Fig. 1.
Fig. 4 is a cross-sectional view taken along line A-A of Fig. 3.
Fig. 5 is a diagram showing an example in which the stage apparatus of Fig. 1 is incorporated in a vacuum chamber.
Fig. 6 is a diagram showing an example in which the stage apparatus of Fig. 1 is incorporated in an exposure apparatus.
Fig. 7 is a cross-sectional view of a stage apparatus according to a modification example.

### Description of Embodiments

Hereinafter, the same or equivalent constituent elements, members, and processes shown in the respective drawings are designated by the same reference numerals, and repeated description will be omitted as appropriate. In addition, the dimensions of the members in each drawing are shown in an appropriately enlarged or reduced size in order to facilitate understanding. In addition, in each drawing, a part of a member which is not important for explaining an embodiment is omitted and displayed.

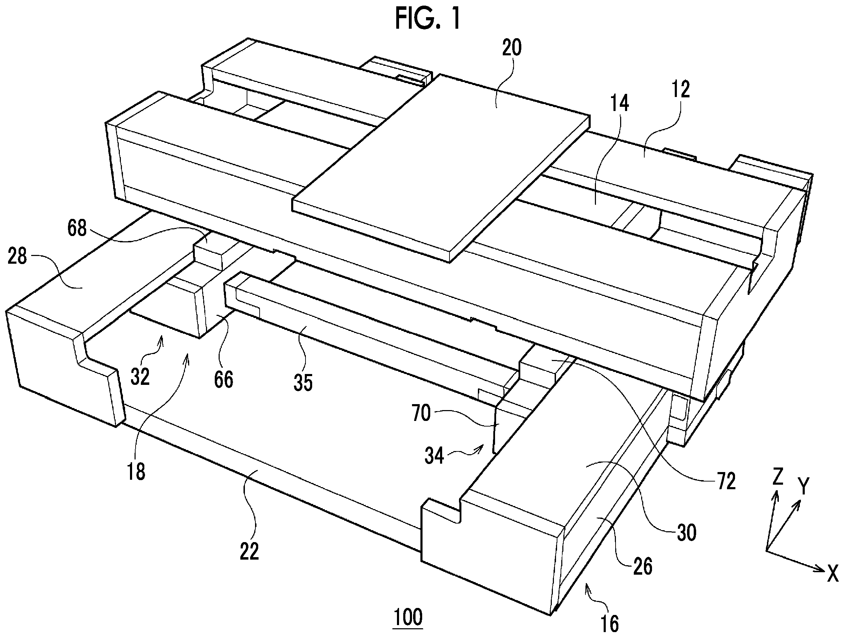

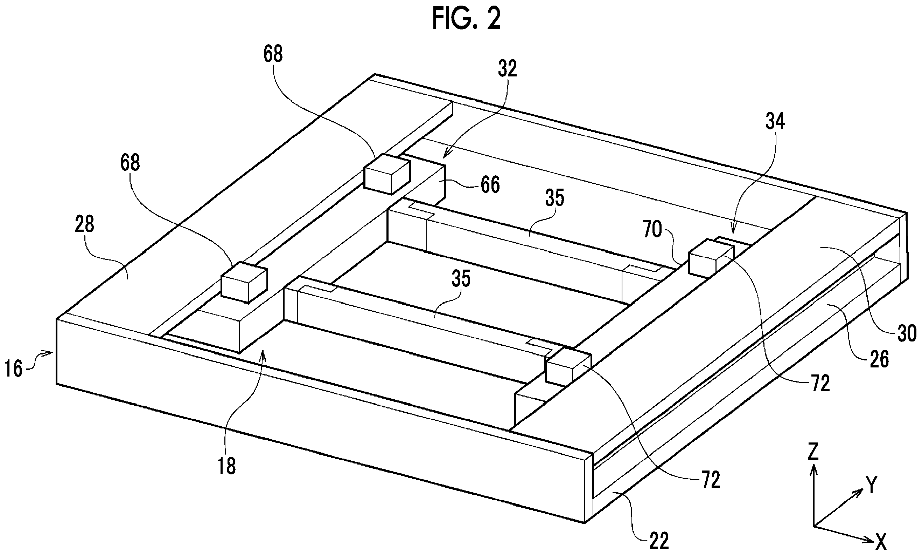

Fig. 1 is a perspective view showing a stage apparatus 100 according to an embodiment. Fig. 2 is a perspective view of a Y-axis guide 16 and a Y-axis slider 18 of the stage apparatus 100 of Fig. 1. For convenience of explanation, as illustrated, an XYZ orthogonal coordinate system is defined in which a direction in which the X-axis guide 12 (described later) extends is an X-axis direction, a direction that is perpendicular to the X-axis direction and in which the Y-axis guide 16 (described later) extends is a Y-axis direction, and a direction perpendicular to both is a Z-axis direction. The stage apparatus 100 is referred to as a stack-type XY stage, and positions an object in the X-axis direction (first direction) and the Y-axis direction (second direction orthogonal to the first direction).

The stage apparatus 100 is a stack-type stage apparatus. The stage apparatus 100 includes an X-axis guide 12, an X-axis slider 14, a Y-axis guide 16, a Y-axis slider 18, and a table 20. The X-axis guide 12 and the X-axis slider 14 are an upper-axis guide and an upper-axis slider, respectively, and the Y-axis guide 16 and the Y-axis slider 18 are a lower-axis guide and a lower-axis slider, respectively. That is, the Y-axis guide 16 and the Y-axis slider 18 are disposed below the X-axis guide 12 and the X-axis slider 14.

The X-axis guide 12 is a long member that is long in the X-axis direction. The X-axis guide 12 is not particularly limited, but has a concave cross section perpendicular to the X-axis direction. The X-axis slider 14 is not particularly limited, but has a cuboid shape, and is accommodated inside the X-axis guide 12. The X-axis slider 14 is guided by the X-axis guide 12 and moves in the X-axis direction. The X-axis slider 14 is not particularly limited, but configures an air slide together with the X-axis guide 12 in the present embodiment, floats with respect to the X-axis guide 12 by compressed gas supplied between the X-axis slider 14 and the X-axis guide 12, and moves along the X-axis guide 12 in a non-contact state with the X-axis guide 12. The X-axis slider 14 may be driven by, for example, an air servo.

The Y-axis slider 18 supports the X-axis guide 12 from below. The Y-axis slider 18 is guided by the Y-axis guide 16 and moves in the Y-axis direction. Therefore, the X-axis guide 12 and the X-axis slider 14 supported by the Y-axis slider 18 move in the Y-axis direction with the movement of the Y-axis slider 18 in the Y-axis direction.

The table 20 is fixed to the X-axis slider 14. For example, a machining object such as a semiconductor wafer is placed on the table 20. By moving the X-axis slider 14 in the X-axis direction and moving the Y-axis slider 18 in the Y-axis direction, the table 20 is moved in the X-axis direction and the Y-axis direction, and the object can be positioned in the X-axis direction and the Y-axis direction.

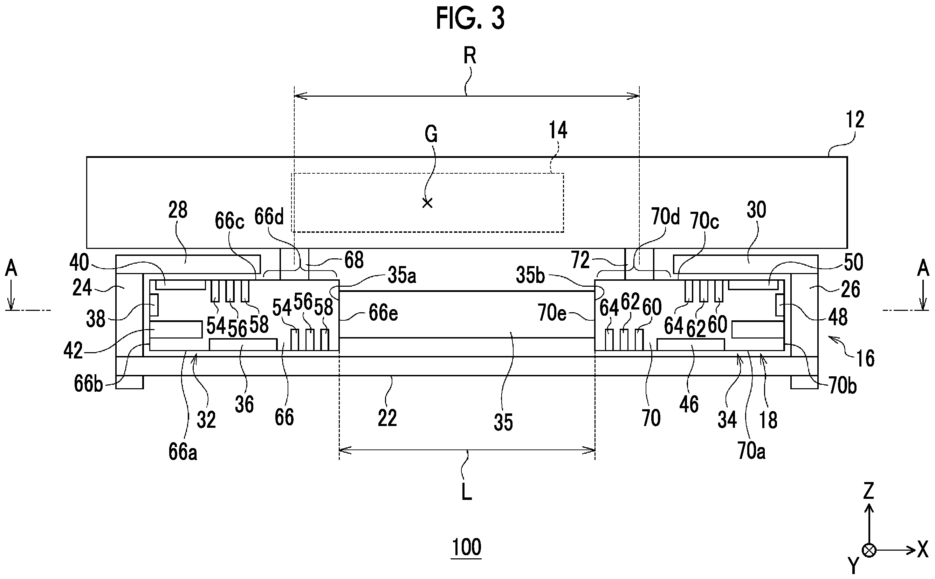

Fig. 3 is a cross-sectional view of the stage apparatus 100 cut along a plane orthogonal to the Y-axis direction. Fig. 3 shows a cross section cut along a plane passing through a connecting portion 35 of the Y-axis slider 18. In Fig. 3, the display of the table 20 is omitted.

The Y-axis guide 16 is a box-shaped member having an opening at the center of the upper surface in the X-axis direction. The Y-axis guide 16 includes a bottom wall 22, a first side wall 24 and a second side wall 26, and a first upper wall 28 and a second upper wall 30.

The bottom wall 22 is a plate member having a rectangular shape in a plan view. The first side wall 24 and the second side wall 26 are vertical walls that are long in the Y-axis direction. The first side wall 24 is erected at one end (left end in Fig. 3) of the bottom wall 22 in the Y-axis direction, and the second side wall 26 is erected at the other end (right end in Fig. 3). The first side wall 24 and the second side wall 26 face each other in the X-axis direction.

The first upper wall 28 and the second upper wall 30 are rectangular plate members long in the Y-axis direction in a plan view. The first upper wall 28 and the second upper wall 30, respectively, are fixed to the upper ends of the first side wall 24 and the second side wall 26 so as to extend toward each other from the upper ends of the first side wall 24 and the second side wall 26.

The Y-axis slider 18 is accommodated inside the Y-axis guide 16. The Y-axis slider 18 includes a first slider part 32 and a second slider part 34 that are separated from each other in the X-axis direction, and two connecting portions 35 that connect the first slider part 32 and the second slider part 34. The number of the connecting portions 35 is not particularly limited and may be one or three or more.

Hereinafter, with respect to the two slider parts 32 and 34, the side near the center of the Y-axis slider 18 in the X-axis direction (that is, the connecting portion 35 side) will be described as the inner side of the two slider parts 32 and 34, and the side far from the center (that is, the side opposite to the connecting portion 35) will be described as the outer side of the two slider parts 32 and 34.

The first slider part 32 includes a cuboid-shaped first main body 66 and a first support leg portion 68 fixed to the upper surface of the first main body 66. The first main body 66 is housed in a space in which an outer portion (a left portion in Fig. 3) in the X-axis direction is surrounded by the bottom wall 22, the first side wall 24, and the first upper wall 28.

The lower surface air pad 36, the side surface air pad 38, and the upper surface air pad 40 are provided on the bottom surface 66a, the outer side surface 66b, and the upper surface 66c of the first main body 66 facing the bottom wall 22, the first side wall 24, and the first upper wall 28. The air pads (restraining members) 36 to 40 eject compressed gas supplied from an air supply system (not illustrated) into a gap between the first main body 66 and the Y-axis guide 16. Accordingly, a high-pressure gas layer is formed in the gap, and the air pads 36 to 40 and the first main body 66 float from the Y-axis guide 16. The air pads 36 to 40 may be provided on the facing surface of the Y-axis guide 16 facing the first main body 66, instead of the outer peripheral surface of the first main body 66. In any case, the first main body 66 is restrained from moving vertically and outward in the X-axis direction with respect to the Y-axis guide 16 by compressed gas ejected from the air pads 36 to 40.

A first air servo chamber 42 for driving the first slider part 32 is formed on the outer side surface 66b of the first main body 66, as will be described later.

The second slider part 34 includes a cuboid-shaped second main body 70 and a second support leg portion 72 fixed to the upper surface of the second main body 70. The second main body 70 is housed in a space in which an outer portion (a right portion in Fig. 3) in the X-axis direction is surrounded by the bottom wall 22, the second side wall 26, and the second upper wall 30.

The lower surface air pad 46, the side surface air pad 48, and the upper surface air pad 50 are provided on the bottom surface 70a, the outer side surface 70b, and the upper surface 70c of the second main body 70 facing the bottom wall 22, the second side wall 26, and the second upper wall 30. The air pads (restraining members) 46 to 50 eject compressed gas supplied from an air supply system (not illustrated) into a gap between the second main body 70 and the Y-axis guide 16. Accordingly, a high-pressure gas layer is formed in the gap, and the air pads 46 to 50 and the second main body 70 float from the Y-axis guide 16. The air pads 46 to 50 may be provided on the facing surface of the Y-axis guide 16 facing the second main body 70, instead of the outer peripheral surface of the second main body 70. In any case, the second main body 70 is restrained from moving vertically and outward in the X-axis direction with respect to the Y-axis guide 16 by compressed gas ejected from the air pads 46 to 50.

A second air servo chamber 52 for driving the second slider part 34 is formed on the outer side surface 70b of the second main body 70, as will be described later.

Exhaust grooves 54, 56, and 58 for differential exhaust are formed on the outer peripheral surface of the first main body 66 of the first slider part 32 to surround the air pads 36 to 40 and the first air servo chamber 42. The exhaust groove 54 is released to the atmosphere. The exhaust groove 54 may be connected to an exhaust pump (not shown). The exhaust grooves 56 and 58 are connected to an exhaust pump (not shown) for setting the pressures in the exhaust grooves to a low vacuum pressure level and a medium vacuum pressure level, respectively, and exhaust the compressed gas supplied from the air pads 36 to 40 and the first air servo chamber 42 of the first main body 66 to the outside.

Exhaust grooves 60, 62, and 64 for differential exhaust are formed on the outer peripheral surface of the second main body 70 of the second slider part 34 to surround the air pads 46 to 50 and the second air servo chamber 52. The exhaust grooves 60, 62, and 64 are configured in the same manner as the exhaust grooves 54, 56, and 58 of the first main body 66.

By preventing the compressed gas from leaking from the gap between the Y-axis guide 16 and the Y-axis slider 18, the stage apparatus 100 can be used even in a vacuum environment. When the stage apparatus 100 is used in an atmospheric pressure environment, it is not necessary to provide such an exhaust groove.

The first support leg portion 68 is placed on a portion 66d of the upper surface 66c of the first main body 66 that protrudes inward (the right side in Fig. 3) in the X-axis direction from the first upper wall 28, and is fixed there. The second support leg portion 72 is placed on a portion 70d of the upper surface 70c of the second main body 70 that protrudes inward (the left side in Fig. 3) in the X-axis direction from the second upper wall 30, and is fixed there. The first support leg portion 68 and the second support leg portion 72 support the X-axis guide 12.

The movable range R of the center of gravity G of the X-axis slider 14 that moves with the movement of the X-axis slider 14 falls between the X-axis direction centers of the first support leg portion 68 and the second support leg portion 72 that support the X-axis guide 12. That is, the X-axis guide 12 is supported at two support positions of the X-axis direction center of the first support leg portion 68 and the X-axis direction center of the second support leg portion 72, and the movable range R of the center of gravity G of the X-axis slider 14 falls between the two support positions.

The lower surface air pad 36, the upper surface air pad 40, and the first support leg portion 68 are disposed such that the center of the lower surface air pad 36 is positioned between the center of the upper surface air pad 40 and the center of the first support leg portion 68 (in other words, a support position that supports the X-axis guide 12, in further other words, the position where the load of the X-axis guide 12 is applied), in the X-axis direction. More specifically, the lower surface air pad 36, the upper surface air pad 40, and the first support leg portion 68 are disposed from the inside to the outside in the X-axis direction such that the center of the first support leg portion 68 in the X-axis direction, the center of the lower surface air pad 36 in the X-axis direction, and the center of the upper surface air pad 40 in the X-axis direction are arranged in this order.

The lower surface air pad 46, the upper surface air pad 50, and the second support leg portion 72 are disposed such that the center of the lower surface air pad 46 is positioned between the center of the upper surface air pad 50 and the center of the second support leg portion 72 (in other words, a support position that supports the X-axis guide 12, in further other words, the position where the load of the X-axis guide 12 is applied), in the X-axis direction. More specifically, the lower surface air pad 46, the upper surface air pad 50, and the second support leg portion 72 are disposed from the inside to the outside in the X-axis direction such that the center of the second support leg portion 72 in the X-axis direction, the center of the lower surface air pad 46 in the X-axis direction, and the center of the upper surface air pad 50 in the X-axis direction are arranged in this order.

The connecting portion 35 is not particularly limited, but in the illustrated example, the connecting portion 35 is a rod member extending in the X-axis direction, and has a rectangular cross section perpendicular to the X-axis direction. The total cross-sectional area of the two connecting portions 35 perpendicular to the X-axis direction is smaller than the cross-sectional area of the first main body 66 or the second main body 70 perpendicular to the X-axis direction. Accordingly, the weight of the Y-axis slider 18 can be reduced as compared with a case where the Y-axis slider 18 is formed as one large slider part, that is, as compared with a case where the Y-axis slider 18 is formed as one large cuboid-shaped member.

The connecting portion 35 connects the first slider part 32 and the second slider part 34 such that the distance between the first slider part 32 and the second slider part 34 in the X-axis direction does not change. In the connecting portion 35 of the illustrated example, the end surfaces 35a and 35b in the X-axis direction are directly connected to the inner end surfaces 66e and 70e of the main bodies 66 and 70. The connecting portion 35 may be connected to the inner end surfaces 66e and 70e of the main bodies 66 and 70 via, for example, an elastic hinge such that the main bodies 66 and 70 can be slightly displaced in the Z-axis direction with respect to the connecting portion 35.

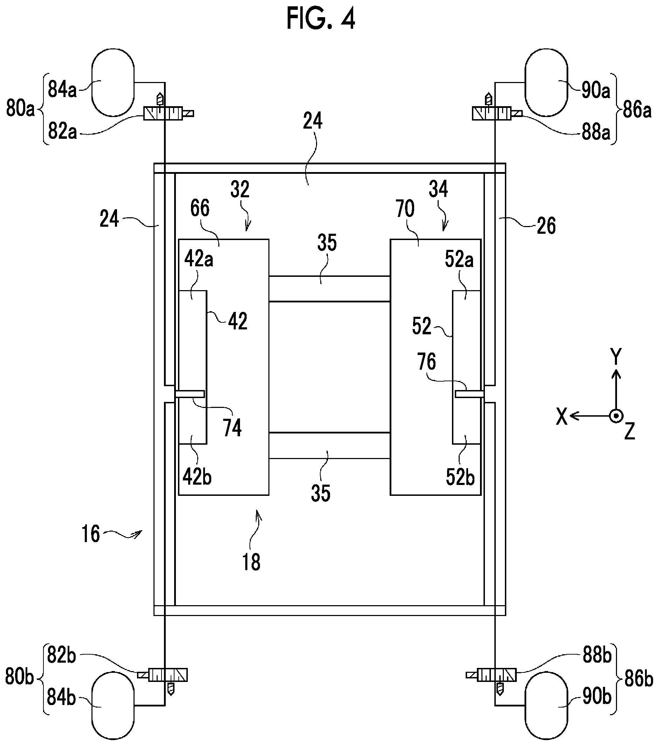

Fig. 4 is a cross-sectional view taken along line A-A of Fig. 3. The principle that the Y-axis slider 18 moves with respect to the Y-axis guide 16 will be described with reference to Fig. 4. The stage apparatus 100 further includes a first partition wall 74 and a second partition wall 76. In Fig. 4, the gap between the Y-axis guide 16 and the slider parts 32 and 34 and the gap between the partition walls 74 and 76 and the air servo chambers 42 and 52 are exaggerated. In practice, for example, these gaps are about several microns.

The first partition wall 74 is fixed to the Y-axis guide 16 and partitions the first air servo chamber 42 into two air servo chambers 42a and 42b in the axial direction. The air supply systems 80a and 80b for allowing the compressed gas to enter and exit are connected to the two air servo chambers 42a and 42b, respectively. The air supply systems 80a and 80b include the servo valves 82a and 82b and the compressed gas supply sources 84a and 84b, respectively.

The second partition wall 76 is fixed to the Y-axis guide 16 and partitions the second air servo chamber 52 into two air servo chambers 52a and 52b in the axial direction. The air supply systems 86a and 86b for allowing the compressed gas to enter and exit are connected to the two air servo chambers 52a and 52b, respectively. The air supply systems 86a and 86b include servo valves 88a and 88b and compressed gas supply sources 90a and 90b, respectively.

When the compressed gas is supplied to the air pads 36 to 40 and 46 to 50, the Y-axis slider 18 slightly floats with respect to the Y-axis guide 16 as described above. In this state, for example, when the compressed gas is supplied to the air servo chambers 42a and 52a and the compressed gas is exhausted from the air servo chambers 42b and 52b, the partition walls 74 and 76 act as pistons, and the slider parts 32 and 34 and the Y-axis slider 18 move downward in Fig. 4. In this way, by controlling the supply and discharge of the compressed gas, the Y-axis slider 18 can be moved to any position with respect to the Y-axis guide 16.

Subsequently, the effects of the present embodiment will be described. In the stack-type stage apparatus in the related art, when the X-axis slider moves, the load fluctuates on the X-axis guide to cause the X-axis guide to tilt around the Y-axis direction, a moment around the Y-axis guide is generated on the Y-axis slider that supports the X-axis guide, and galling may occur where the Y-axis slider comes into contact with the Y-axis guide. On the other hand, according to the stage apparatus 100 according to the present embodiment, the Y-axis slider 18 includes two slider parts 32 and 34 that support the X-axis guide 12 and a connecting portion 35 that connects the two slider parts 32 and 34. That is, since the Y-axis slider 18 has the connecting portion 35 between the two slider parts 32 and 34, the X-axis guide 12 can be supported with a support span longer by the length of the connecting portion 35. Accordingly, the support rigidity around the Y-axis direction increases compared to the case where the connecting portion 35 is not provided and the X-axis guide 12 is supported with a short support span, and as a result, galling where the Y-axis slider 18 comes into contact with the Y-axis guide 16 is prevented.

Further, according to the stage apparatus 100 according to the embodiment, the movable range R of the center of gravity G of the X-axis slider 14 that moves with the movement of the X-axis slider 14 falls between the two support leg portions 68 and 72 that support the X-axis guide 12 (that is, two support positions). That is, the movable range R of the center of gravity G of the X-axis slider 14 falls within the support span of the Y-axis slider 18. Accordingly, when the X-axis slider 14 moves and a load fluctuates on the X-axis guide 12, it is possible to prevent the X-axis guide 12 from tilting around the Y-axis direction, and as a result, galling caused by the Y-axis slider 18 coming into contact with the Y-axis guide 16 is further prevented.

Further, according to the stage apparatus 100 according to the embodiment, the lower surface air pad, the upper surface air pad, and the support leg portion are disposed such that the lower surface air pad is positioned between the upper surface air pad and the support leg portion in the X-axis direction. Accordingly, when a downward load is applied to the slider part via the support leg portion with the movement of the X-axis slider 14, it is possible to prevent the slider part from tilting around the Y-axis direction, and as a result, galling caused by the Y-axis slider 18 coming into contact with the Y-axis guide 16 is further prevented.

Subsequently, an application example of the present embodiment will be described.

The stage apparatus 100 according to the embodiment may be incorporated as a constituent element of equipment or an apparatus used in a clean environment such as a clean room or a vacuum chamber. For example, in semiconductor manufacturing apparatus such as an exposure apparatus, an ion implanter, a heat treatment apparatus, an edging apparatus, a sputtering apparatus, and an inspection apparatus, the stage apparatus 100 of the present embodiment is suitable for use in precisely controlling the position of a work table on which a semiconductor wafer or the like to be processed is placed.

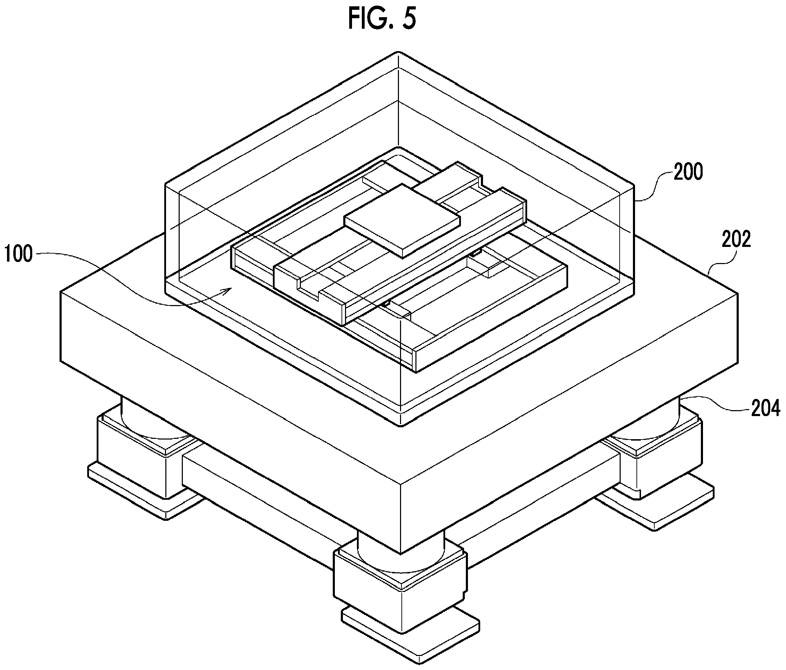

Fig. 5 is a view showing an example in which the stage apparatus 100 is incorporated in a vacuum chamber. In Fig. 5, the display of the air supply system is omitted. The stage apparatus 100 is supported by a platen 202. The platen 202 is supported by the vibration isolation table 204. The vibration isolation table 204 absorbs the vibration from the floor where the stage apparatus 100 is disposed, and reduces the vibration of the platen 202 and the stage apparatus 100.

The stage apparatus 100 is accommodated in the vacuum chamber 200. The inside of the vacuum chamber 200 is maintained at a predetermined degree of vacuum. That is, in this example, the stage apparatus 100 is used in a vacuum environment (in a vacuum atmosphere).

In the stage apparatus 100, the slider configures an air slide together with the guide, floats with respect to the guide, and moves along the guide in a non-contact state with the guide. Therefore, the inside of the vacuum chamber 200 can be kept clean, without generating lubricating oil or fine dust from the sliding surface like when using a rolling bearing or a linear guide between the slider and the guide.

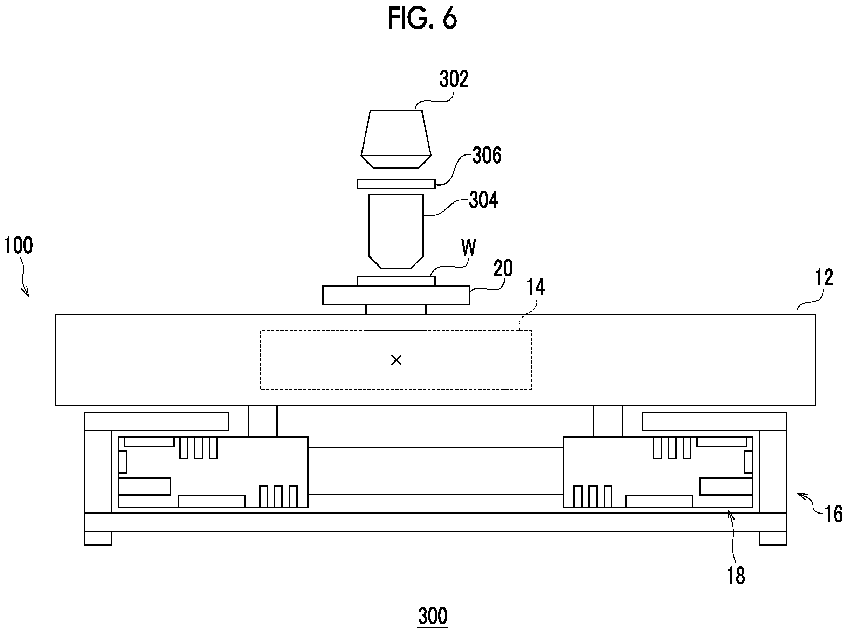

Fig. 6 is a diagram showing an example in which the stage apparatus 100 is incorporated in the exposure apparatus. The exposure apparatus 300 is used in manufacturing a semiconductor device such as a semiconductor integrated circuit, and various devices such as a micromachine and a thin-film magnetic head.

The stage apparatus 100 positions the wafer W which is a substrate. A light source 302 and an optical system 304 expose and transfer the pattern of the reticle (mask) 306 to each region of the positioned wafer W by a step-and-scan method.

A device manufacturing method will be described. The reticle 306 is created based on the designed circuit pattern. On the other hand, the wafer W is created by using a predetermined material such as silicon. Next, a circuit is formed on the wafer W by a lithography technique, by using the reticle 306 and the wafer W. Specifically, the circuit pattern of the reticle 306 is exposed and transferred to the wafer W by the exposure apparatus 300. Next, the wafer W on which the circuit pattern is transferred is made into a semiconductor chip. This process includes, for example, a known assembly process (dicing, bonding) and a packaging process (chip encapsulation). Finally, the semiconductor device is inspected by the inspection apparatus. In this process, the stage apparatus 100 positions the semiconductor device as a constituent element of the inspection apparatus and inspects the positioned semiconductor device.

The present invention has been described above based on the embodiment. The embodiment is an example, and it is understood by those skilled in the art that various modification examples are possible for each of the constituent elements and combinations of the respective processing processes of the embodiment, and that such modification examples are also within the scope of the present invention. Hereinafter, a modification example will be described.

### (MODIFICATION EXAMPLE 1)

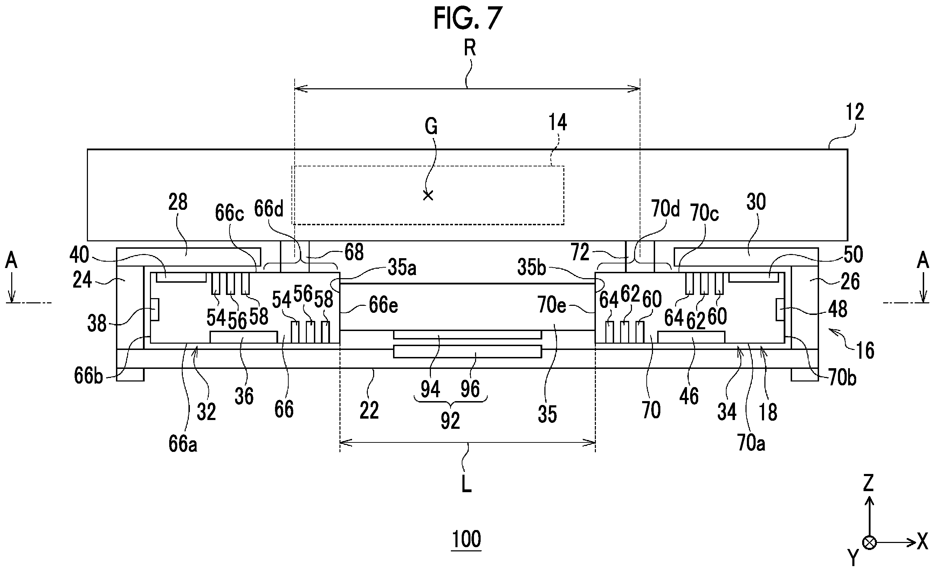

Fig. 7 is a cross-sectional view of the stage apparatus 100 according to a modification example. Fig. 7 corresponds to Fig. 3. In the present modification, the Y-axis slider 18 does not include an air servo chamber. Instead, the stage apparatus 100 includes a linear motor 92. That is, the Y-axis slider 18 is driven by the linear motor 92 instead of the air servo. The linear motor 92 includes a magnet 94 fixed to the Y-axis slider 18, and a plurality of electromagnets 96 fixed to the Y-axis guide 16 to be aligned in the Y-axis direction. In this example, the magnet 94 is fixed to the connecting portion 35, but the present invention is not limited thereto, and for example, the magnet 94 may be fixed to at least one of the first slider part 32 and the second slider part 34. According to the present embodiment, the same effects as those of the embodiment can be achieved.

Any combination of the above-described embodiment and modification example is also useful as an embodiment of the present invention. The new embodiment generated by the combination has the effect of each of the embodiment and the modification example to be combined. In addition, it is also understood by those skilled in the art that the functions to be fulfilled by each of the constituent elements described in the claims are implemented by a single or a combination of the constituent elements shown in the embodiment and modification example.

### Industrial Applicability

The present invention relates to a stage apparatus, an exposure apparatus, an inspection apparatus, and a device manufacturing method.

### Reference Signs List

12 X-axis guide
14 X-axis slider
16 Y-axis guide
18 Y-axis slider
32 first slider part
34 second slider part
35 connecting portion
36, 46 lower surface air pad
40, 50 upper surface air pad
100 stage apparatus

## Claims

1. A stage apparatus comprising:
a first slider;
a first guide that guides movement of the first slider in a first direction;
a second slider that includes two slider parts separated from each other in the first direction and supporting the first guide from below; and
a second guide that guides movement of the second slider.

2. The stage apparatus according to claim 1, wherein
the stage apparatus is used in a vacuum environment.

3. The stage apparatus according to claim 1 or 2, wherein
the second slider includes a connecting portion that connects the two slider parts.

4. The stage apparatus according to claim 3, wherein
a cross-sectional area of the connecting portion perpendicular to the first direction is smaller than cross-sectional areas of the slider parts perpendicular to the first direction.

5. The stage apparatus according to any one of claims 1 to 4, wherein
the first slider is driven by an air servo.

6. The stage apparatus according to any one of claims 1 to 5, wherein
the second slider is driven by an air servo.

7. The stage apparatus according to any one of claims 1 to 5, wherein
the second slider is driven by a linear motor.

8. The stage apparatus according to any one of claims 1 to 7, wherein
a movable range of a center of gravity of the first slider that moves with the movement of the first slider is between two support positions in the first direction in which the two slider parts support the first guide.

9. The stage apparatus according to any one of claims 1 to 8, further comprising:
a restraining member for restraining vertical movement of the two slider parts with respect to the second guide, in a state where the two slider parts are non-contact with the second guide.

10. The stage apparatus according to claim 9, wherein the restraining member is an air pad.

11. The stage apparatus according to claim 9 citing claim 8, wherein
the restraining member is upper surface air pads and lower surface air pads that are disposed on upper surfaces and lower surfaces of the two slider parts and inject compressed gas toward a facing surface of the second guide, and
the lower surface air pads are provided between the upper surface air pads and the support positions in the first direction.

12. An exposure apparatus comprising:
the stage apparatus according to any one of claims 1 to 11, wherein
the exposure apparatus positions a substrate by using the stage apparatus.

13. An inspection apparatus comprising:
the stage apparatus according to any one of claims 1 to 11, wherein
the inspection apparatus positions a substrate by using the stage apparatus.

14. A device manufacturing method comprising:
a step of manufacturing a device by using the exposure apparatus according to claim 12.

## Amended claims

### Amended claims under Art. 19.1 PCT

1. A stage apparatus comprising:
a first slider;
a first guide that guides movement of the first slider in a first direction;
a second slider that includes two slider parts separated from each other in the first direction and supporting the first guide from below; and
a second guide that guides movement of the second slider.

2. The stage apparatus according to claim 1, wherein
the stage apparatus is used in a vacuum environment.

3. The stage apparatus according to claim 1 or 2, wherein
the second slider includes a connecting portion that connects the two slider parts.

4. The stage apparatus according to claim 3, wherein
a cross-sectional area of the connecting portion perpendicular to the first direction is smaller than cross-sectional areas of the slider parts perpendicular to the first direction.

5. The stage apparatus according to any one of claims 1 to 4, wherein
the first slider is driven by an air servo.

6. The stage apparatus according to any one of claims 1 to 5, wherein
the second slider is driven by an air servo.

7. The stage apparatus according to any one of claims 1 to 5, wherein
the second slider is driven by a linear motor.

8. The stage apparatus according to any one of claims 1 to 7, wherein
a movable range of a center of gravity of the first slider that moves with the movement of the first slider is between two support positions in the first direction in which the two slider parts support the first guide.

9. The stage apparatus according to any one of claims 1 to 8, further comprising:
a restraining member for restraining vertical movement of the two slider parts with respect to the second guide, in a state where the two slider parts are non-contact with the second guide.

10. The stage apparatus according to claim 9, wherein the restraining member is an air pad.

11. The stage apparatus according to claim 9 citing claim 8, wherein
the restraining member is upper surface air pads and lower surface air pads that are disposed on upper surfaces and lower surfaces of the two slider parts and inject compressed gas toward a facing surface of the second guide, and
the lower surface air pads are provided between the upper surface air pads and the support positions in the first direction.

12. An exposure apparatus comprising:
the stage apparatus according to any one of claims 1 to 11, wherein
the exposure apparatus positions a substrate by using the stage apparatus.

13. An inspection apparatus comprising:
the stage apparatus according to any one of claims 1 to 11, wherein
the inspection apparatus positions a substrate by using the stage apparatus.

14. A device manufacturing method comprising:
a step of manufacturing a device by using the exposure apparatus according to claim 12.

15. (Added) A stage apparatus comprising:
a first slider;
a first guide that guides movement of the first slider in a first direction;
a second slider that includes two slider parts separated from each other in the first direction and supporting the first guide from below; and
a second guide that guides movement of the second slider, wherein
the first slider and the second slider are driven by an air servo.
